# EUROPEAN PATENT APPLICATION

(11) **EP 2 398 079 A1**
(43) Date of publication of application: **21.12.2011**
(21) Application number: 10769763.3
(22) Date of filing: 27.04.2010
(51) Int. Cl.: H01L 33/48, F21S 8/04, H01L 33/00, H01L 33/50, F21Y 101/02

(54) **ILLUMINATING DEVICE**

(30) Priority: 27.04.2009 JP 2009108078; 01.03.2010 JP 2010044704
(71) Applicant: Toshiba Lighting&Technology Corporation, Yokosuka-shi, Kanagawa 237-8510 (JP); Kabushiki Kaisha Toshiba, Minato-ku Tokyo 105-8001 (JP)
(72) Inventor: ISHIWATA, Tomoko, Yokosuka-shi Kanagawa 237-8510 (JP); YASHIRO, Kazunori, Yokosuka-shi Kanagawa 237-8510 (JP); YAMAZAKI, Izao, Yokosuka-shi Kanagawa 237-8510 (JP); UCHINO, Kazutoshi, Yokosuka-shi Kanagawa 237-8510 (JP); MITA, Kazutoshi, Yokosuka-shi Kanagawa 237-8510 (JP); KAWANO, Hitoshi, Yokosuka-shi Kanagawa 237-8510 (JP)
(74) Representative: Kramer - Barske - Schmidtchen
(86) International application number: PCT/JP2010/057508
(87) International publication number: WO 2010/126065

(57) **Abstract**

A lighting apparatus includes a red LED; a green LED; a blue LED; and a white LED made up of a blue light-emitting element and a yellow phosphor, wherein the red LED, the green LED, the blue LED, and the white LED generate 26 to 38%, 35 to 50%, 0 to 2%, and 12 to 33% of light, respectively, and white light obtained by additive color mixing of light from the red, green, blue, and white LEDs has a correlated color temperature of 2800 K or more to less than 3500 K, a deviation of 0.02 or below in absolute value, and a color gamut area ratio of 120% or more to 140% or less. Consequently, the lighting apparatus can radiate an illuminating light which makes colors look vivid.

## Description

### Technical Field

The present invention relates to a lighting apparatus equipped with a light source such as a light emitting diode (LED).

### Background Art

Conventionally, light source devices equipped with light sources such as LEDs are used as white light sources of lighting apparatuses. In particular, light source devices whose light sources are made up of blue LEDs and yellow phosphors are capable of providing a high luminous efficiency and a large luminous flux, and are in the mainstream of white light sources.

Examples of this type of light source include a variable-color light emitting diode device described in Japanese Patent Application Laid-Open Publication No. 2005-101296 (hereinafter referred to as Document 1). The variable-color light emitting diode device includes a single-color light emitting part provided with an LED chip which glows in monochrome; and a white light emitting part provided with another LED chip, wherein the white light emitting part is made up of a blue LED chip which glows in a blue color and a phosphor which glows in a yellow color (corresponding to a yellow phosphor).

The white light emitting part described in Document 1 obtains white light by shining blue light emitted by a blue LED on the phosphor of yellow color which is produced by a combination of red color and green color, i.e., the rest of the three primary colors.

However, a light source made up of such a blue LED and yellow phosphor is low in long wavelength emission components, and thus has a problem in that the light source causes especially the red color to look pale. That is, the pale-looking red color means that illuminating light radiated from the light source is white light which is low in a red component.

Methods for evaluating color rendering properties of a light source include a method stipulated by JIS Z 8726 (Japanese Industrial Standard: Color Rendering Property Evaluation Method for Light Sources). The evaluation method illuminates 15 test colors with a sample light source and a reference illumination light and quantifies magnitudes of color shifts caused by the sample light source.

An average color rendering index (Ra) is an average value of special color rendering indices for eight colors of No. 1 to No. 8 color rendering test colors while the special color rendering indices (R9) are color rendering indices for individual test colors.

With the color rendering property evaluation method, the color rendering index for a reference light is taken as 100, and the larger the color shift, the smaller the color rendering index. That is, a light source with high color-rendering properties has a large color rendering index value while a light source with low color-rendering properties has a small color rendering index value.

Conventionally, also in lighting apparatuses which employ LEDs and the like, color rendering properties of light sources have been evaluated using a color rendering evaluation method which employs color rendering indices, and mainly an average color rendering index (Ra). However, such a color rendering property evaluation method uses relative evaluation with respect to a reference light source and is not a sufficient method for making colors look vivid. Thus, conventional light source devices have a problem in that the effect of making colors look vivid cannot be fully evaluated.

### Disclosure of Invention

### Means for Solving the Problem

According to a first aspect of the present invention, there is provided a lighting apparatus including: a red LED which has a peak wavelength of emission spectrum in a range of 610 to 630 nm and a full width at half maximum in a range of 10 to 20 nm; a green LED which has a peak wavelength of emission spectrum in a range of 500 to 520 nm and a full width at half maximum in a range of 20 to 30 nm; a blue LED which has a peak wavelength of emission spectrum in a range of 450 to 470 nm and a full width at half maximum in a range of 10 to 20 nm; and a white LED made up of a blue light-emitting element and a yellow phosphor, wherein the red LED generates light at a flux ratio of between 26 and 38%; the green LED generates light at a flux ratio of between 35 and 50%; the blue LED generates light at a flux ratio of between 0 and 2%; the white LED generates light at a flux ratio of between 12 and 33%; white light is obtained by additive color mixing of light from the red, green, blue, and white LEDs; the white light has a correlated color temperature of 2800 K or more to less than 3500 K, a deviation of 0.02 or below in absolute value, and a color gamut area ratio of 120% or more to 140% or less when the white light is used as a test light, where the color gamut area ratio is a ratio between a color gamut area formed by connecting eight points in chromaticity coordinates when JIS color rendering test colors No. 1 to No. 8 are lighted by the test light and a color gamut area formed by connecting eight points in the chromaticity coordinates when the JIS color rendering test colors No. 1 to No. 8 are lighted by a reference light.

In the lighting apparatus according to the first aspect of the present invention, the red LED generates light at a flux ratio of between 18 and 31%; the green LED generates light at a flux ratio and between 28 to 46%; the blue LED generates light at a flux ratio of between 0 and 2%; the white LED generates light at a flux ratio of between 23 and 52%; white light is obtained by additive color mixing of light from the red, green, blue, and white LEDs; and the white light has a correlated color temperature of 3500 K or more to less than 5000, a deviation of 0.02 or below in absolute value, and a color gamut area ratio of 120% or more to 140% or less when the white light is used as the test light.

In the lighting apparatus according to the first aspect of the present invention, the red LED generates light at a flux ratio of between 18 and 30%; the green LED generates light at a flux ratio of between 28 and 57%; the blue LED generates light at a flux ratio of between 0 and 3%; the white LED generates light at a flux ratio of between 15 and 52%; white light is obtained by additive color mixing of light from the red, green, blue, and white LEDs; and the white light has a correlated color temperature of 5000 K or more to 10000 K or less, a deviation of 0.02 or below in absolute value, and a color gamut area ratio of 110% or more to 140% or less when the white light is used as the test light.

In the lighting apparatus according to the first aspect of the present invention, a plurality of the red, green, blue, and white LEDs are provided; and out of the red, green, blue, and white LEDs, LEDs complementary to each other are placed adjacent to each other and LEDs of a same type are arranged point-symmetrically.

The lighting apparatus according to the first aspect of the present invention further includes, an RGB sensor configured to detect a red component, a green component, and a blue component of incident light; a diffuser plate configured to transmit and reflect light from the red, green, blue, and white LEDs; a light shielding member configured to block direct light from the red, green, blue, and white LEDs and give mixed light from the diffuser plate to the RGB sensor; and a control unit configured to keep flux ratios of the light from the red, green, blue, and white LEDs constant based on detection results produced by the RGB sensor.

According to a second aspect of the present invention, there is provided a lighting apparatus including: a light source configured to radiate an illuminating light by additively mixing color lights from a red LED, a green LED, a blue LED, and a white LED, wherein the light source has a color gamut area ratio of 105% or more to 140% or less when the illuminating light radiated from the light source is used as a test light, has a chroma difference of 4 or above between the illuminating light and a reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light, has a correlated color temperature of 2800 K or more to less than 5000 K, and has a deviation duv of 0.02 or below in absolute value, where the color gamut area ratio is a ratio between a color gamut area formed by connecting eight points in chromaticity coordinates when JIS color rendering test colors No. 1 to No. 8 are lighted by the test light and a color gamut area formed by connecting eight points in the chromaticity coordinates when the JIS color rendering test colors No. 1 to No. 8 are lighted by the reference light.

In the lighting apparatus according to the second aspect of the present invention, the light source has a color gamut area ratio of 105% or more to 140% or less when the illuminating light radiated from the light source is used as the test light, has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 2800 K or more to less than 3500 K, and has a deviation duv of 0.02 or below in absolute value.

In the lighting apparatus according to the second aspect of the present invention, the light source has a color gamut area ratio of 105% or more to 140% or less when the illuminating light radiated from the light source is used as the test light, has a chroma difference of 2 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 5000 K or above, and has a deviation duv of 0.02 or below in absolute value.

In the lighting apparatus according to the second aspect of the present invention, the light source has a color gamut area ratio of 105% or more to 140% or less when the illuminating light radiated from the light source is used as the test light, has an area of 0° to 45° or an area of 315° to 360° in terms of an ab hue angle (hab) (No. 9) of first chromaticity on an a*b* chromaticity coordinate diagram when the first chromaticity is plotted on the a*b* chromaticity coordinate diagram with a color chip of JIS color rendering test color No. 9 lighted by the illuminating light radiated from the light source, has an area of 135° to 225° in terms of an ab hue angle (hab) (No. 11) of second chromaticity on the a*b* chromaticity coordinate diagram when the second chromaticity is plotted on the a*b* chromaticity coordinate diagram with a color chip of JIS color rendering test color No. 11 lighted by the illuminating light, has a correlated color temperature of 2800 K or more to less than 5000 K, and has a deviation duv of 0.02 or below in absolute value.

In the lighting apparatus according to the second aspect of the present invention, the light source has a color gamut area ratio of 105% or more to 140% or less when the illuminating light radiated from the light source is used as the test light, has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light, has a correlated color temperature of 2800 K or more to less than 5000 K, has a deviation duv of 0.02 or below in absolute value, and has an area of 0° to 45° or an area of 315° to 360° in terms of an ab hue angle (hab) (No. 9) of first chromaticity on the a*b* chromaticity coordinate diagram when the first chromaticity is plotted on the a*b* chromaticity coordinate diagram with a color chip of JIS color rendering test color No. 9 lighted by the illuminating light.

In the lighting apparatus according to the second aspect of the present invention, the light source has a color gamut area ratio of 105% or more to 140% or less when the illuminating light radiated from the light source is used as the test light, has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 2800 K or more to less than 3500 K, has a deviation duv of 0.02 or below in absolute value, and has an area of 135° to 225° in terms of an ab hue angle (hab) (No. 11) of second chromaticity on the a*b* chromaticity coordinate diagram when the second chromaticity is plotted on the a*b* chromaticity coordinate diagram with a color chip of JIS color rendering test color No. 11 lighted by the illuminating light.

In the lighting apparatus according to the second aspect of the present invention, the light source has a color gamut area ratio of 105% or more to 140% or less when the illuminating light radiated from the light source is used as the test light, has a chroma difference of 2 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 5000 K, has a deviation duv of 0.02 or below in absolute value, and has an area of 135° to 225° in terms of an ab hue angle (hab) (No. 11) of second chromaticity on the a*b* chromaticity coordinate diagram when the second chromaticity is plotted on the a*b* chromaticity coordinate diagram with a color chip of JIS color rendering test color No. 11 lighted by the illuminating light.

In the lighting apparatus according to the first aspect of the present invention, white light is obtained by additive color mixing of light from the red, green, blue, and white LEDs; and the white light has a color gamut area ratio of 105% or more to 140% or less when the white light is used as the test light and has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light.

In the lighting apparatus according to the first aspect of the present invention, white light is obtained by additive color mixing of light from the red, green, blue, and white LEDs; and the white light has a color gamut area ratio of 105% or more to 140% or less when the white light is used as the test light and has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light.

In the lighting apparatus according to the first aspect of the present invention, white light is obtained by additive color mixing of light from the red, green, blue, and white LEDs; and the white light has a color gamut area ratio of 105% or more to 140% or less when the white light is used as the test light and has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light.

In the lighting apparatus according to the first aspect of the present invention, white light is obtained by additive color mixing of light from the red, green, blue, and white LEDs; and the white light has a color gamut area ratio of 105% or more to 140% or less when the white light is used as the test light and has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light.

In the lighting apparatus according to the first aspect of the present invention, white light is obtained by additive color mixing of light from the red, green, blue, and white LEDs; and the white light has a color gamut area ratio of 105% or more to 140% or less when the white light is used as the test light and has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light.

In the lighting apparatus according to the first aspect of the present invention, white light is obtained by additive color mixing of light from the red, green, blue, and white LEDs; the white light has a color gamut area ratio of 105% or more to 140% or less when the white light is used as the test light and has a chroma difference of 2 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light.

The lighting apparatus according to the first aspect of the present invention further includes: an apparatus body in which the red LED, the green LED, the blue LED, and the white LED are disposed; and a lighting control device configured to control an ON state or an OFF state of the red LED, the green LED, the blue LED, and the white LED.

### Brief Description of the Drawings

Fig. 1 is a block diagram relating to an embodiment of a lighting apparatus equipped with a light source device according to the present invention and showing a schematic configuration of the lighting apparatus;
Fig. 2 is a block diagram showing a concrete configuration of an RGB chip 3b shown in Fig. 1;
Fig. 3 is a graph showing a spectral distribution of a white LED 3a;
Fig. 4 is a graph showing a spectral distribution of the RGB chip 3b;
Fig. 5 is a graph showing a spectral distribution of a light source made up of a combination of the white LED 3a and the RGB chip 3b;
Fig. 6 is a graph showing color gamut areas obtained by plotting chromaticities on a chromaticity diagram when four colors-color rendering test colors No. 9 to No. 12--are lighted by illuminating lights of a light source device 3, reference light, and a white LED, where the reference light is taken as 100;
Fig. 7 is a graph showing color gamut areas obtained by plotting chromaticities on a chromaticity diagram when eight colors--color rendering test colors No. 1 to No. 8--are lighted by illuminating lights of the light source device 3, reference light, and a white LED, where the reference light is taken as 100;
Fig. 8 is a flowchart for determining a color gamut area ratio and the like;
Fig. 9 is an explanatory diagram for illustrating characteristics of a lighting apparatus designed according to the flowchart in Fig. 8;
Fig. 10 is a block diagram showing a schematic configuration of a light source device;
Fig. 11 is an explanatory diagram showing external appearance of a lighting apparatus incorporating the light source device shown in Fig. 10;
Fig. 12 is an explanatory diagram showing a planar shape of the light source device;
Fig. 13 is an explanatory diagram showing a sectional shape of the light source device and part of a lighting control device;
Fig. 14 is a graph for illustrating a fifth embodiment of the present invention;
Fig. 15 is a graph for illustrating the fifth embodiment of the present invention;
Fig. 16 is a graph for illustrating the fifth embodiment of the present invention;
Fig. 17 is a graph for illustrating the fifth embodiment of the present invention;
Fig. 18 is a graph for illustrating the fifth embodiment of the present invention;
Fig. 19 is a graph for illustrating the fifth embodiment of the present invention;
Fig. 20 is a graph for illustrating a sixth embodiment of the present invention;
Fig. 21 is a graph for illustrating the sixth embodiment of the present invention;
Fig. 22 is a graph for illustrating the sixth embodiment of the present invention; and
Fig. 23 is an explanatory diagram for illustrating a seventh embodiment of the present invention.

### Best Mode for Carrying Out the Invention

Embodiments of the present invention will be described below with reference to the drawings.

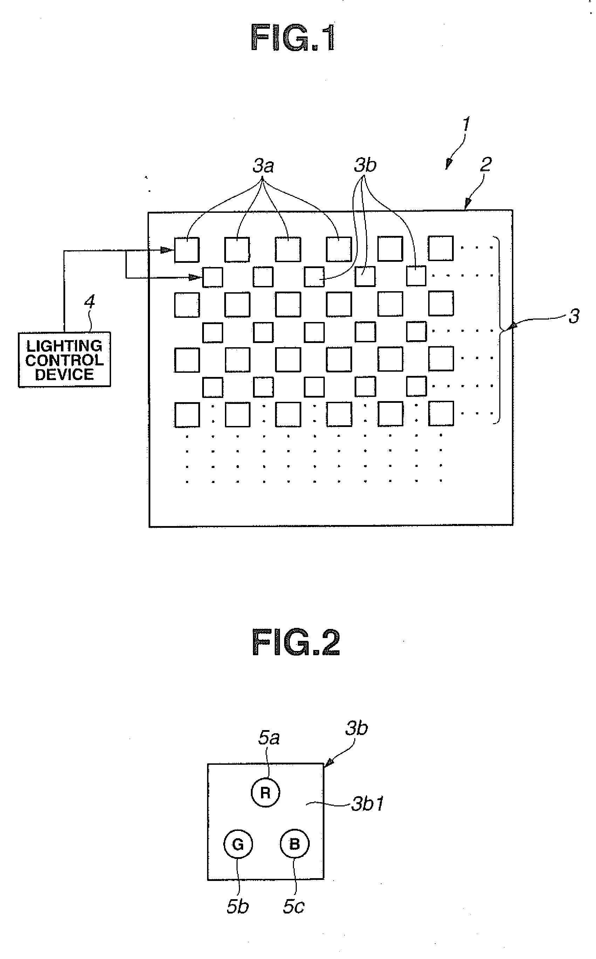

Fig. 1 is a block diagram relating to an embodiment of a lighting apparatus according to the present invention and showing a schematic configuration of the lighting apparatus.

As shown in Fig. 1, the lighting apparatus 1 according to the present embodiment includes an apparatus body 2, a light source device 3 disposed in the apparatus body 2, and a lighting control device 4 configured to control an ON state or an OFF state of the light source device 3.

The apparatus body 2 is placed, for example, on a ceiling in a building and formed into a shape in which the light source device 3 can be disposed. The apparatus body 2 is formed into a low-profile enclosure shape or a plate shape, but the apparatus body 2 is not limited to these shapes and may have any shape as long as the light source device 3 can be disposed therein.

The light source device 3 includes a light source made up of a plurality of white LEDs 3a configured to emit a first white light and a plurality of RGB chips 3b configured to emit a second white light. The light source gives off an illuminating light which is a white light produced by mixing the first white light and the second white light.

The white LEDs 3a are made up of a blue LED chip which glows in a blue color and a yellow phosphor which glows in a yellow color. For example, the white LEDs 3a include a resin portion in which the yellow phosphor is scattered over epoxy resin so as to cover the blue LED chip although not illustrated.

A configuration of the RGB chips 3b which make up the light source in conjunction with the white LEDs 3a is shown in Fig. 2. Fig. 2 is a block diagram showing a concrete configuration of the RGB chip 3b.

As shown in Fig. 2, the RGB chip 3b includes a red LED (RLED) 5a which glows in a red color (R), a green LED (GLED) 5b which glows in a green color (G), and a blue LED (BLED) 5c which glows in a blue color (B). The LEDs 5a to 5c of the RGB colors are configured to be disposed on a substrate 3b1.

As shown in Fig. 1, the light source device 3 is configured by disposing a plurality of the white LEDs 3a in a vertical and lateral directions of the apparatus body 2 and disposing a plurality of RGB chips 3b in such a way as to surround each RGB chip 3b, for example, with four white LEDs 3a.

Of course, placement locations of the white LEDs 3a and RGB chips 3b are not limited to the configuration shown in Fig. 1, and may be changed as required.

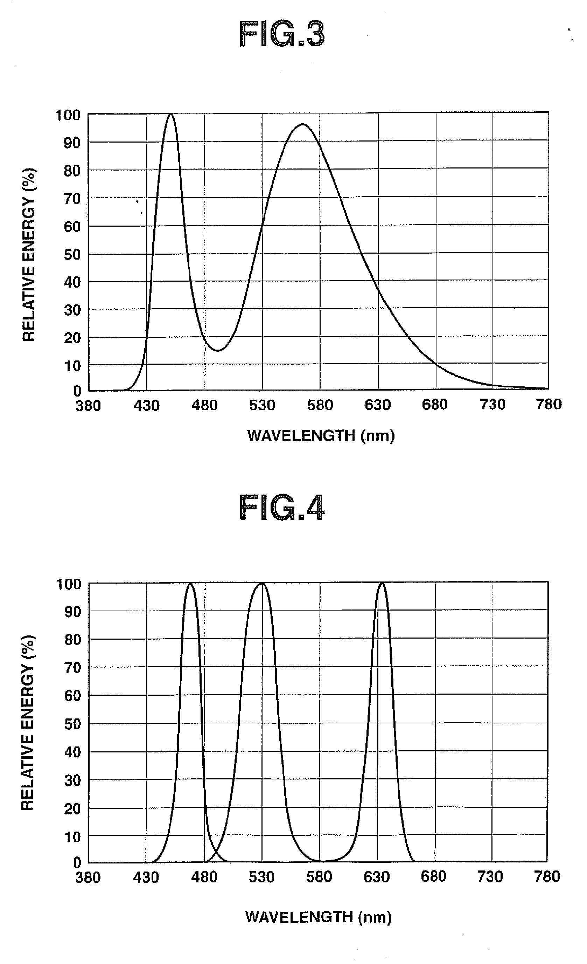

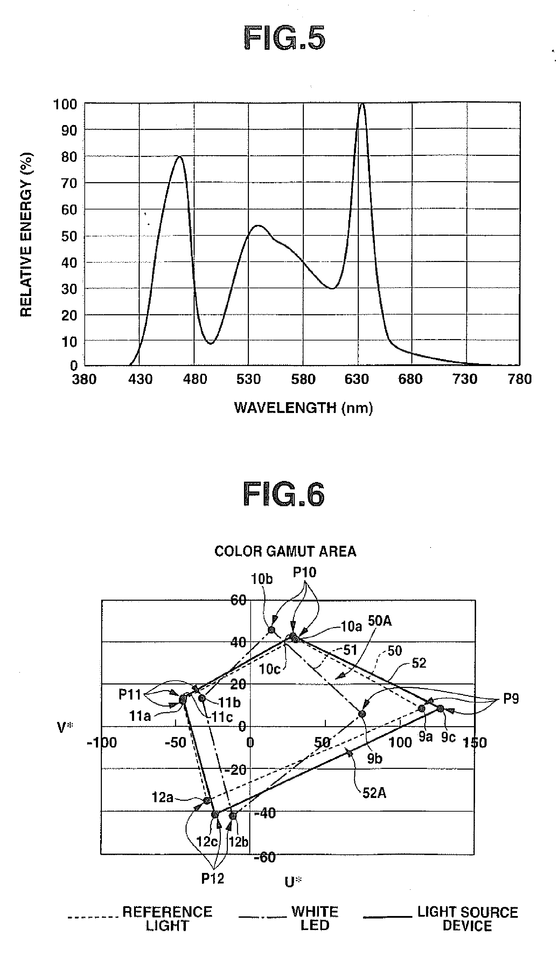

Fig. 3 is a graph showing a spectral distribution of the white LEDs 3a, Fig. 4 is a graph showing a spectral distribution of the RGB chip 3b, and Fig. 5 is a graph showing a spectral distribution of a light source made up of a combination of the white LEDs 3a and the RGB chip 3b, where the abscissa represents wavelength and the ordinate represents a relative value (relative energy) with respect to the wavelength.

As shown by the spectral distribution in Fig. 3, the white LEDs 3a have optical characteristics whereby a blue component has a peak relative value between about 430 (nm) and 450 (nm) and a yellow component has a peak relative value between about 540 (nm) and 570 (nm). Of course, the white LEDs 3a are not limited to have the spectral distribution shown in Fig. 3, and may have another spectral distribution as long as the spectral distribution contains a blue component and a yellow component.

By radiating light with such a spectral distribution, the white LEDs 3a provide the first white light.

On the other hand, as shown by the spectral distribution in Fig. 4, the RGB chips 3b have optical characteristics whereby a blue component has a peak relative value between about 460 (nm) and 470 (nm), a green component has a peak relative value between about 520 (nm) and 530 (nm), and a red component has a peak relative value between about 630 (nm) and 640 (nm). Of course, the RGB chips 3b are not limited to have the spectral distribution shown in Fig. 4, and may have another spectral distribution as long as the spectral distribution contains a blue component, a green component, and a red component.

By radiating light with such a spectral distribution, the RGB chips 3b provide the second white light.

According to the present embodiment, the light source of the light source device 3 is made up of a combination of the white LEDs 3a and RGB chips 3b with such spectral characteristics. Consequently, the light source of the light source device 3 radiates, as illuminating light, the white light produced by mixing the first white light from the white LEDs 3a and the second white light from the RGB chips 3b.

A spectral distribution of the light source of the light source device 3 is shown in Fig. 5.

That is, as shown in Fig. 5, the light source of the light source device 3 has optical characteristics whereby a blue component has a peak relative value between about 460 (nm) and 470 (nm), a green component has a peak relative value between about 530 (nm) and 540 (nm), and a red component has a peak relative value between about 630 (nm) and 640 (nm).

This configuration allows the light source of the light source device 3 to radiate white light complemented with a red component as shown in Fig. 5 compared to conventional white light produced using only white LEDs.

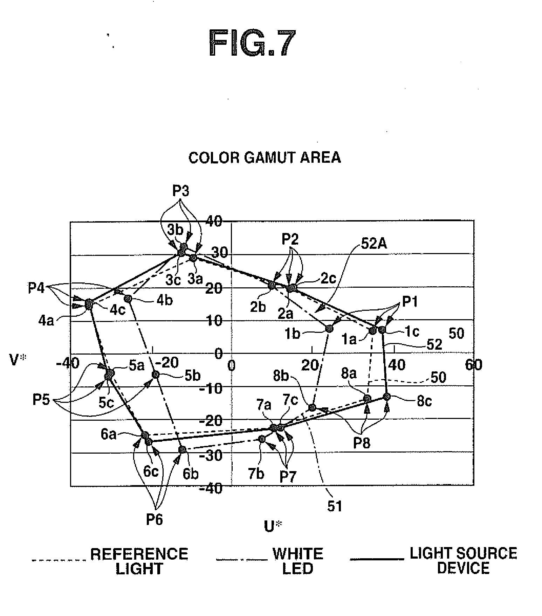

According to the present embodiment, the light source device 3 (light source) with these characteristics is configured to satisfy evaluation conditions for color rendering (described later). The evaluation conditions for color rendering properties of the light source will be described with reference to Figs. 6 and 7.

Fig. 6 is a graph showing color gamut areas obtained by plotting chromaticities on a chromaticity diagram when four colors--color rendering test colors No. 9 to No. 12--are lighted by illuminating lights of the light source device 3 according to the present embodiment, a reference light, and a white LED.

Fig. 7 is a graph showing color gamut areas obtained by plotting chromaticities on a chromaticity diagram when eight colors--color rendering test colors No. 1 to No. 8--are lighted by illuminating lights of the light source device 3 according to the present embodiment, the reference light, and the white LED.

In Figs. 6 and 7, out of the 15 test colors stipulated by JIS Z 8726 (described above), chromaticities of eight colors--color rendering test colors No. 1 to No. 8--and four colors--color rendering test colors No. 9 to No. 12--are denoted by P 1 to P12. Also, in Figs. 6 and 7, a broken line represents a reference light 50, a dashed line represents a white LED 51, and a solid line represents the light source 52 of the light source device 3 according to the present embodiment.

The light source 52 of the light source device 3 according to the present embodiment forms a polygon corresponding to the light source 52 when at least three or more types of color chips which differ in hue are lighted by illuminating light radiated from the light source 52, chromaticities of the color chips are plotted on a chromaticity diagram, and plotted points are connected.

Also, the light source 52 of the light source device 3 forms a polygon corresponding to a reference light when the at least three types of color chips are lighted by the reference light equal in correlated color temperature to the illuminating light from the light source 52, chromaticities of the color chips are plotted on the chromaticity diagram, and plotted points are connected.

The light source 52 of the light source device 3 can radiate an illuminating light which is such a white light that the ratio of the area of the polygon corresponding to the light source 52 to the area of the polygon corresponding to the reference light will be larger than 1.

For example, when the four color chips P9 to P12 of color rendering test colors No. 9 to No. 12 stipulated by JIS Z 8726 (described above) are lighted by irradiating light of the reference light 50 and resulting chromaticities are plotted on a chromaticity diagram, chromaticity points 9a, 10a, 11a, and 12a corresponding to the color chips P9 to P12 are obtained as shown in Fig. 6.

Similarly, when the four color chips P9 to P12 of color rendering test colors No.9 to No. 12 are lighted by irradiating light of the white LED 51 and resulting chromaticities are plotted on the chromaticity diagram, chromaticity points 9b, 10b, 11b, and 12b corresponding to the color chips P9 to P12 are obtained as shown in Fig. 6.

Similarly, when the four color chips P9 to P12 of color rendering test colors No. 9 to No. 12 are lighted by irradiating light of the light source 52 of the light source device 3 according to the present embodiment and resulting chromaticities are plotted on the chromaticity diagram, chromaticity points 9c, 10c, 11c, and 12c corresponding to the color chips P9 to P12 are obtained as shown in Fig. 6.

Then, in Fig. 6, when the chromaticity points are connected for each of the reference light 50, the white LED 51, and the light source 52 of the light source device 3, respective quadrangles are formed. The areas of the quadrangles are designated as color gamut areas 50A, 51A, and 52A.

It is assumed that the reference light 50 is equal in correlated color temperature to the irradiating light from the light source 52 of the light source device 3.

When the color gamut area 50A (hereinafter referred to as the color gamut area of the reference light 50) of the polygon formed by connecting the chromaticity points corresponding to the reference light 50 is taken as 100, the color gamut area 52A (hereinafter referred to as the color gamut area of the light source 52) of the polygon formed by connecting the chromaticity points corresponding to the light source 52 is calculated to be 119 as shown in Table 1 below. That is, the ratio of the color gamut area 52A of the light source 52 to the color gamut area 50A of the reference light 50 is 1.19, which is larger than 1.

**[Table 1]**

| | White LED | White LED + red, green, and blue LEDs |
|---|---|---|
| Average color rendering index Ra | 59 | 90 |
| Special color rendering index R9 | -89 | 42 |
| Color gamut areas of color rendition test colors No. 1 to No. 8 | 76 | 108 |
| Color gamut areas of color rendition test colors No. 9 to No. 12 | 76 | 119 |

Also, the color gamut area 51A (hereinafter referred to as the color gamut area of the white LED 51) of the polygon formed by connecting the chromaticity points corresponding to the white LED 51 is 76 as shown in Table 1 above. Thus, it can be seen that the ratio of the color gamut area 51A of the white LED 51 to the color gamut area 50A of the reference light 50 is 0.76, which is smaller than the color gamut area ratio of the light source 52 according to the present embodiment.

Also, for example, when the eight color chips P1 to P8 of color rendering test colors No. 1 to No. 8 stipulated by JIS Z 8726 (described above) are lighted by the irradiating light of the reference light 50 and resulting chromaticities are plotted on a chromaticity diagram, chromaticity points 1a, 2a, 3a, 4a, 6a, 7a, and 8a corresponding to the color chips P1 to P8 are obtained as shown in Fig. 7.

Also, when the eight color chips P1 to P8 of color rendering test colors No. 1 to No. 8 are lighted by the white LED 51 and resulting chromaticities are plotted on the chromaticity diagram, chromaticity points 1b, 2b, 3b, 4b, 5b, 6b, 7b, and 8b corresponding to the color chips P1 to P8 are obtained as shown in Fig. 7.

Furthermore, when the eight color chips P1 to P8 of color rendering test colors No. 1 to No. 8 are lighted by the irradiating light of the light source 52 of the light source device 3 according to the present embodiment and resulting chromaticities are plotted on the chromaticity diagram, chromaticity points 1c, 2c, 3c, 4c, 5c, 6c, 7c, and 8C corresponding to the color chips P1 to P8 are obtained as shown in Fig. 7.

Then, in Fig. 6, when the chromaticity points are connected for each of the reference light 50, the white LED 51, and the light source 52 of the light source device 3, respective octagons are formed. The areas of the octagons are designated as color gamut areas 50A, 51A, and 52A.

When the color gamut area 50A of the reference light 50 is taken as 100, the color gamut area 52A of the light source 52 is calculated to be 108 as shown in Table 1 above. That is, the ratio of the color gamut area 52A of the light source 52 to the color gamut area 50A of the reference light 50 is 1.08, which again is larger than 1.

Again, similarity to the above, also in this case, the color gamut area 51A of the white LED 51 is 76 as shown in Table 1 above. Thus, it can be seen that the ratio of the color gamut area 51A of the white LED 51 to the color gamut area 50A of the reference light 50 is 0.76, which is smaller than the color gamut area ratio of the light source 52 according to the present embodiment.

The four color chips P9 to P12 (red, yellow, green, and blue) of color rendering test colors No. 9 to No. 12 have relatively high color saturation. Thus, the use of the color gamut area ratios of color rendering test colors No. 9 to No. 12 for a color rendering evaluation method for a light source makes it possible to evaluate the capability of an illuminating light to make relatively vivid colors look more vivid.

In this case, since the chromaticity of red, i.e., color rendering test color No. 9, in particular, is higher than the reference light 50 as shown in Fig. 6, the irradiating light of the light source device 3 provides a white light which can make red look far more vivid than the white LED 51 can.

Also, in the present embodiment, the color gamut area ratio of the color gamut area 52A, which is formed when the eight color chips P1 to P8 of color rendering test colors No. 1 to No. 8 stipulated by JIS Z 8726 (described above) are lighted by the irradiating light of the light source device 3, to the color gamut area 50A of the reference light 50 is 1.08 as shown in Fig. 7 and Table 1 (presented above). In particular, the chromaticities of color rendering property test colors Nos. 1, 3, 6, and 8 are higher than the reference light 50 as shown in Fig. 7, resulting in a white light which can make the colors look much more vivid than the white LED 51 can.

Thus, by satisfying the conditions for making the color gamut area ratios of the color rendering test colors stipulated by JIS Z 8726 larger than 1, the light source device 3 according to the present embodiment can radiate a white light complemented especially with a red component.

Incidentally, since the reference light 50 has an average color rendering index (Ra) of 100, the closer the ratio of the color gamut area of the test light(shown in Fig. 6) to 1, the larger the average color rendering index (Ra) of the test light by which color chips of color rendering test colors No. 1 to No. 8 are lighted to obtain the color gamut area.

Thus, in the present embodiment, the color gamut area ratio of the color gamut area 52A, which is formed when the eight color chips P1 to P8 of color rendering test colors No. 1 to No. 8 stipulated by JIS Z 8726 (described above) are lighted by the irradiating light of the light source device 3, to the color gamut area 50A of the reference light 50 is 1.08 as shown in Fig. 6 and Table 1 (presented above), and is closer to 1 than 0.76 which is the color gamut area ratio of the color gamut area 51A of the white LED 51 to the color gamut area 50A of the reference light. Thus, the irradiating light of the light source device 3 also has a higher average color rendering index (R9) than the white LED 51 does and thereby provides good color rendering properties.

That is, the larger the color gamut area ratio, the more vivid the color can be made to look; and the closer the color gamut area ratio is to 1, the closer to 100 the average color rendering index (Ra) can be made. Preferably, for example, the color gamut area ratio is larger than 1 but not larger than 1.2, and more preferably not larger than about 1.1.

According to the present embodiment the color gamut areas are controlled by appropriately setting luminous fluxes of the white LEDs 3a and RGB chips 3b which make up the light source of the light source device 3.

For the purpose of reference, to obtain the color gamut area ratio shown in Table 1 presented above, light mixing ratios (luminous flux ratios) among colors are set to be red : yellow : green : blue : white = 14.7 : 18.8 : 3.4 : 100.

Of course, the light mixing ratios (luminous flux ratios) described above may be changed as required according to the usage of the illuminating light. For example, an illuminating light with a larger color gamut area 52A may be obtained by decreasing the ratio of white and increasing the ratios of red, green, and blue.

The light source of the light source device 3 was actually constructed from the white LEDs 3a and the RGB chips 3b made up of the red LEDs 5a, green LEDs 5b, and blue LEDs 5c and an experiment was conducted to subjectively evaluate changes in how an object looked under a mixed light of these colors.

As a result, when a chromatically colored object was observed under an illuminating light created by mixing the lights from the red LEDs 5a, the green LEDs 5b, and the blue LEDs 5c, the object generally looked more saturated in color, so that an illuminated space appeared clear and beautiful.

Thus, by stipulating a color rendering evaluation method for making colors look vivid and by constructing a light source of the light source device 3 based on the color rendering evaluation method, the present embodiment can implement the light source device 3 equipped with a light source capable of radiating an illuminating light which makes colors look vivid as well as implement the lighting apparatus 1 using the light source device 3.

Incidentally, although the present embodiment changes the spectral distribution of the irradiating light of the light source device 3 by adding the RGB chips 3b to the white LEDs 3a, this is not restrictive. For example, by adding only the red LEDs 5a to the white LEDs 3a and thereby controlling the color gamut area ratio, it is possible, for example, to make red colors look vivid. Also, by selecting a phosphor material for a color desired to look vivid, the light mixing ratio for the desired color may be increased according to the usage of the illuminating light or the space to be lighted.

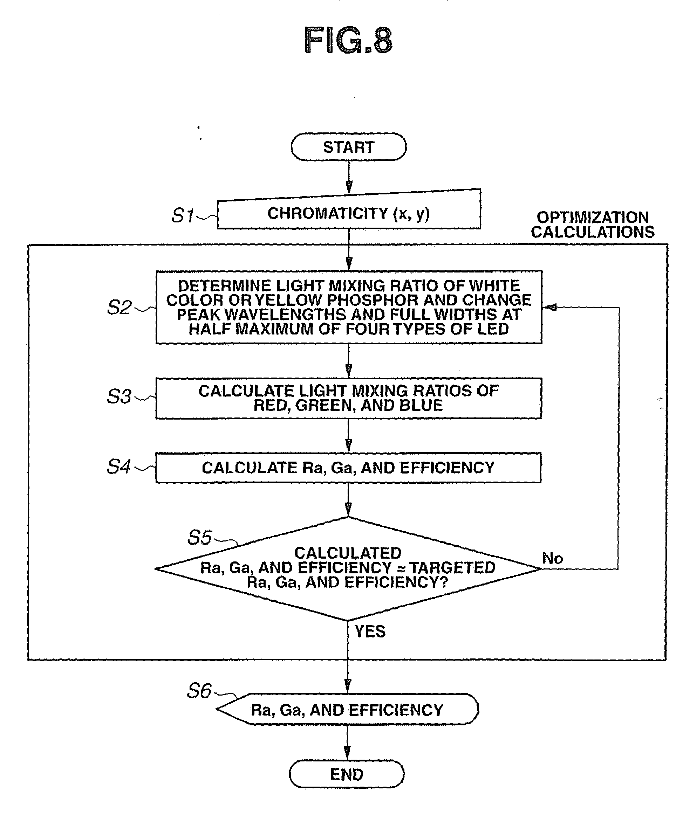

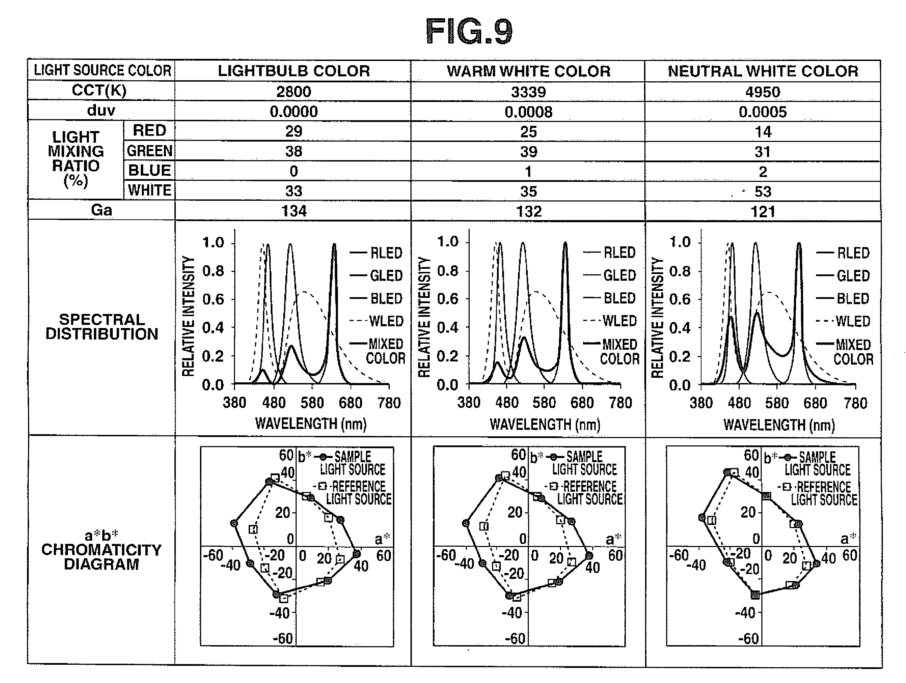

Figs. 8 and 9 are related to a second embodiment of the present invention, where Fig. 8 shows a flowchart for determining a color gamut area ratio and the like and Fig. 9 is an explanatory diagram for illustrating characteristics of a lighting apparatus designed according to the flowchart in Fig. 8.

The present embodiment allows the color gamut area ratio, average color rendering index (Ra), and efficiency to be designed to desired values for a lighting apparatus configured as shown in Fig. 1.

As described above, even if illumination has the same correlated color temperature and average color rendering index (Ra), the color of light can be made to look much more vivid if the color gamut area ratio is set appropriately. The color gamut area ratio can be controlled by setting the light mixing ratios (luminous flux ratios) appropriately among the LEDs of different colors.

According to the present embodiment, again a light source device includes four LEDs in total: a white LED made up of a blue LED which glows in a blue color and a yellow phosphor which glows in a yellow color; and three LEDs---a red LED, a green LED, and a blue LED---used to produce a white light. The present embodiment can be designed by running a computer program corresponding to a flow in Fig. 8 on a computer.

A spectral distribution of a single type of LED is expressed by a linear combination of Gaussian distributions and a spectral distribution of multiple types of LED can be stipulated by controlling a full width at half maximum, a peak wavelength, and a light mixing ratio of each LED. The lighting apparatus designed in the present embodiment has a desired correlated color temperature and deviation as well as a targeted efficiency, an average color rendering index Ra, and a color gamut area ratio Ga. In the present embodiment, by varying the full width at half maximum, the peak wavelength, and the light mixing ratio of each LED so as to obtain such a spectral distribution of the light source, a desired spectral distribution is obtained through optimization calculations.

First, in step S1, set values of chromaticity (x, y) are inputted, where x, y are coordinate values in chromaticity coordinates. According to the present embodiment, the computer sets the light mixing ratio (luminous flux ratio) of the white LED, and then determines the light mixing ratios of the other LED---the red LED, green LED, and blue LED--in accordance with the light mixing ratio of the white LED.

That is, in step S2, the computer determines the peak wavelength and full width at half maximum for each of the four types of LED. Next, the computer calculates the light mixing ratios of the red LED, green LED, and blue LED (step S3), and then calculates the average color rendering index Ra, the color gamut area ratio Ga, and the efficiency (step S4).

The computer determines whether or not the average color rendering index Ra, the color gamut area ratio Ga, and the efficiency found in step S4 have reached target values. If the target values have not been reached, the computer returns to step S2 to reset the light mixing ratios of the red LED, green LED, and blue LED. Subsequently, the computer repeats steps S2 to S5 in a similar manner until the average color rendering index Ra, the color gamut area ratio Ga, and the efficiency reach target values. Once the average color rendering index Ra, the color gamut area ratio Ga, and the efficiency reach target values, the computer outputs resulting values in step S6.

According to the present embodiment, a control unit (not shown) in the lighting control device controls driving of the LEDs based on the values outputted in step S6. That is, by controlling the driving of the LEDs based on the full width at half maximum, the peak wavelength, and a power ratio of each LED chip determined so as to provide a spectral distribution optimized in the manner described above, the control unit configures the lighting apparatus to provide high efficiency and make lighted objects look vivid.

Tables 2 to 5 below show calculation results of the optimization calculations shown in Fig. 8. Tables 2 to 5 show examples of settings used to obtain 2800K, 3500K, 5000K, or 10000K, respectively, as a targeted color gamut area ratio Ga.

In Tables 2 to 5, each setting example is assigned a number (No.); a peak wavelength and full width at half maximum are set for each of the red LED (R), green LED (G), and blue LED (B); and light mixing ratios of the red LED (R), green LED (G), blue LED (B), and white LED (W) are shown in percentage. Also, Tables 2 to 5 show the color gamut area ratio Ga and efficiency resulting from the settings of the peak wavelength, the full width at half maximum, and the light mixing ratio (the color gamut area ratio Ga in Tables 2 to 5 are expressed in relation to the color gamut area of the reference light, which is taken as 100).

**[Table 2]**

| **■** 2800 K | | | | | | | | | | | | |
|---|---|---|---|---|---|---|---|---|---|---|---|---|
| No. | Peak wavelength (nm) | | | Full width at half maximum (nm) | | | Light mixing ratio (%) | | | | Ga | Efficiency |
| | R | G | B | R | G | B | R | G | B | W | | |
| 1 | 630 | 520 | 470 | 20 | 30 | 10 | 33 | 39 | 0 | 28 | 124 | 293 |
| 2 | 630 | 520 | 470 | 20 | 30 | 20 | 33 | 39 | 0 | 28 | 124 | 293 |
| 3 | 630 | 520 | 450 | 20 | 30 | 20 | 38 | 49 | 0 | 12 | 125 | 284 |
| 4 | 630 | 520 | 470 | 10 | 30 | 10 | 31 | 41 | 0 | 27 | 129 | 290 |
| 5 | 630 | 520 | 470 | 10 | 30 | 20 | 31 | 41 | 0 | 27 | 129 | 290 |
| 6 | 630 | 520 | 470 | 20 | 20 | 20 | 33 | 35 | 0 | 33 | 129 | 293 |
| 7 | 630 | 520 | 470 | 20 | 20 | 10 | 33 | 35 | 0 | 33 | 129 | 293 |
| 8 | 630 | 520 | 450 | 10 | 30 | 20 | 35 | 50 | 0 | 15 | 130 | 283 |
| 9 | 630 | 520 | 470 | 10 | 20 | 20 | 31 | 37 | 0 | 32 | 134 | 291 |
| 10 | 630 | 520 | 470 | 10 | 20 | 10 | 31 | 37 | 0 | 32 | 134 | 291 |

**[Table 3]**

| ■ 3500 K | | | | | | | | | | | | |
|---|---|---|---|---|---|---|---|---|---|---|---|---|
| No. | Peak wavelength (nm) | | | Full width at half maximum (nm) | | | Light mixing ratio (%) | | | | Ga | Efficiency |
| | R | G | B | R | G | B | R | G | B | W | | |
| 11 | 630 | 520 | 470 | 20 | 30 | 10 | 27 | 40 | 1 | 32 | 123 | 292 |
| 12 | 630 | 520 | 470 | 20 | 30 | 20 | 29 | 43 | 2 | 26 | 124 | 288 |
| 13 | 630 | 520 | 470 | 20 | 20 | 10 | 29 | 40 | 2 | 29 | 127 | 287 |
| 14 | 630 | 520 | 470 | 20 | 20 | 20 | 31 | 43 | 2 | 24 | 128 | 282 |
| 15 | 630 | 520 | 470 | 10 | 30 | 10 | 26 | 43 | 1 | 30 | 128 | 289 |
| 16 | 630 | 520 | 470 | 10 | 30 | 20 | 28 | 46 | 2 | 25 | 129 | 285 |
| 17 | 630 | 520 | 470 | 10 | 20 | 10 | 28 | 42 | 2 | 28 | 132 | 284 |
| 18 | 630 | 520 | 470 | 10 | 20 | 20 | 30 | 45 | 2 | 23 | 134 | 280 |

**[Table 4]**

| ■ 5000 K | | | | | | | | | | | | |
|---|---|---|---|---|---|---|---|---|---|---|---|---|
| No. | Peak wavelength (nm) | | | Full width at half ( maximum (nm) | | | Light mixing ratio (%) | | | | Ga | Efficiency |
| | R | G | B | R | G | B | R | G | B | W | | |
| 19 | 630 | 500 | 470 | 20 | 20 | 20 | 19 | 28 | 1 | 51 | 110 | 261 |
| 20 | 630 | 500 | 470 | 20 | 20 | 10 | 19 | 28 | 1 | 52 | 110 | 262 |
| 21 | 630 | 500 | 450 | 20 | 20 | 20 | 21 | 33 | 0 | 46 | 113 | 256 |
| 22 | 630 | 500 | 470 | 10 | 20 | 10 | 18 | 30 | 1 | 52 | 113 | 260 |
| 23 | 630 | 500 | 470 | 20 | 30 | 10 | 23 | 38 | 1 | 38 | 114 | 259 |
| 24 | 630 | 500 | 450 | 20 | 20 | 10 | 21 | 33 | 0 | 45 | 114 | 256 |
| 25 | 630 | 500 | 470 | 10 | 20 | 20 | 18 | 30 | 1 | 51 | 114 | 258 |
| 26 | 630 | 500 | 470 | 20 | 30 | 20 | 23 | 39 | 1 | 37 | 115 | 258 |
| 27 | 630 | 500 | 450 | 20 | 30 | 10 | 25 | 43 | 0 | 32 | 117 | 255 |
| 28 | 630 | 500 | 450 | 20 | 30 | 20 | 25 | 43 | 0 | 32 | 117 | 255 |
| 29 | 630 | 500 | 450 | 10 | 20 | 10 | 20 | 34 | 0 | 45 | 117 | 254 |
| 30 | 630 | 500 | 450 | 10 | 20 | 20 | 20 | 34 | 0 | 46 | 117 | 254 |
| 31 | 630 | 500 | 470 | 10 | 30 | 10 | 22 | 40 | 1 | 37 | 118 | 256 |
| 32 | 630 | 500 | 470 | 10 | 30 | 20 | 22 | 41 | 1 | 37 | 119 | 256 |
| 33 | 630 | 500 | 450 | 10 | 30 | 10 | 23 | 44 | 0 | 32 | 121 | 253 |
| 34 | 630 | 500 | 450 | 10 | 30 | 20 | 23 | 44 | 0 | 32 | 121 | 253 |

**[Table 5]**

| ■ 10000 K | | | | | | | | | | | | |
|---|---|---|---|---|---|---|---|---|---|---|---|---|
| NO. | Peak wavelength (nm) | | | Full width at half maximum (nm) | | | Light mixing ratio (%) | | | | Ga | Efficiency |
| | R | G | B | R | G | B | R | G | B | W | | |
| 35 | 610 | 500 | 450 | 10 | 20 | 10 | 30 | 50 | 2 | 18 | 116 | 243 |
| 36 | 630 | 500 | 450 | 10 | 20 | 10 | 26 | 57 | 2 | 15 | 136 | 209 |

As shown in Tables 2 to 5, the color gamut area ratio Ga is 120 or above in setting examples No. 1 to 18, and 110 or above in setting examples No. 19 to 34. As the control unit in the lighting control device sets the full width at half maximum, the peak wavelength, and the light mixing ratio of each LED based on these calculation results, the illumination from the lighting apparatus can make colors look vivid.

Table 6 below shows maximum values and minimum values of the light mixing ratio extracted from Tables 2 to 5 above and classified by the correlated color temperature and thereby shows variation in the light mixing ratio of the LEDs with changes in the correlated color temperature.

**[Table 6]**

| | 2800 | 2800 | 3500 | 3500 | 5000 | 5000 | 10000 | 10000 |
|---|---|---|---|---|---|---|---|---|
| | Minimum value | Maximum value | Minimum value | Maximum value | Minimum value | Maximum value | Minimum value | Maximum value |
| R(%) | 31 | 38 | 26 | 31 | 18 | 25 | 26 | 30 |
| G(%) | 35 | 50 | 40 | 46 | 28 | 44 | 50 | 57 |
| B(%) | 0 | 0 | 1 | 2 | 0 | 1 | 2 | 2 |
| W(%) | 12 | 33 | 23 | 32 | 32 | 52 | 15 | 18 |

Fig. 9 is an explanatory diagram relating light mixing ratios needed to obtain a light bulb color which is a light source color around 2800 K in Table 2, a warm white color which is a light source color around 3500 K, and a neutral white color which is a light source color around 5000 K to spectral distributions and chromaticity diagrams.

Fig. 9 shows an example which uses a red LED with a peak wavelength of 630 nm and a full width at half maximum of 20 nm, a green LED with a peak wavelength of 520 nm and a full width at half maximum of 40 nm, and a blue LED with a peak wavelength of 460 nm and a full width at half maximum of 20 nm.

In Fig. 9, in the example of obtaining a lighting apparatus of light bulb color, i.e., a lighting apparatus with a correlated color temperature (CCT) of 2800 K and a deviation (duv) of 0.0000 in absolute value, it can be seen that a color gamut area ratio Ga of 134 is available if the light mixing ratio among the red LED (R), green LED (G), blue LED (B), and white LED (W) is set to 29:38:0:33.

Similarly, in the case of a lighting apparatus with a correlated color temperature (CCT) of 3339 K and a deviation (duv) of 0.0008 in absolute value, it can be seen that a color gamut area ratio Ga of 132 is available if the light mixing ratio among the red LED (R), green LED (G), blue LED (B), and white LED (W) is set to 25:39:1:35.

Similarly, in the case of a lighting apparatus with a correlated color temperature (CCT) of 4950 K and a deviation (duv) of 0.0005 in absolute value, it can be seen that a color gamut area ratio Ga of 121 is available if the light mixing ratio among the red LED (R), green LED (G), blue LED (B), and white LED (W) is set to 14:31:2:53.

Incidentally, although target values are set for the color gamut area ratio Ga in the examples described in Tables 2 to 5 and Fig. 9, it is obvious that target values may be set for the average color rendering index Ra and the efficiency.

The luminous flux ratios shown in Tables 2 to 5 and Fig. 9 and the like can be achieved with the apparatus shown in Fig. 1. For example, the luminous flux ratios can be controlled if resistors (not shown) are connected in parallel to the LEDs shown in Fig. 1 and values of current passed through the LEDs are controlled by the control unit in the lighting control device.

Incidentally, the red LED might undergo a sharp drop in output with the passage of time, compared to the other LEDs, i.e., the green LED, the blue LED, or the white LED. Thus, in a lighting apparatus expected to be used for long hours, the output of the red LEDs may be set to approximately 1.5 times the luminous flux ratio that is supposed to be set normally.

Also, in the case of additive color mixing, the power ratio among the LEDs does not necessarily have to be controlled by means of current, and may be controlled by the number of LEDs. For example, with the current flowing through all the LEDs kept constant, the luminous flux ratio may be controlled by changing the number of LEDs installed in the light source device among different colors and thereby varying the power ratio.

In this way, by controlling the full width at half maximum, peak wavelength, and light mixing ratio of each LED, the present embodiment can provide a lighting apparatus which has a desired correlated color temperature and deviation as well as the targeted efficiency, the average color rendering index Ra, and the color gamut area ratio Ga. For example, the present embodiment can provide a white illumination LED lamp which looks vivid by having a color gamut area ratio Ga of between 120 and 170 (both inclusive) while having a desired correlated color temperature.

Also, the present embodiment allows such a lighting apparatus to be designed using a program, and thereby reduces the time required for design. Furthermore, the efficiency of the lighting apparatus can be set appropriately, which is advantageous in terms of economical efficiency.

Incidentally, to set the light mixing ratio of the white LED in the embodiment described above, the light mixing ratio of the white LED may be controlled by controlling emission of the yellow phosphor in the white LED.

Also, although the program shown in Fig. 8 expands the color gamut areas of JIS color rendering test colors No. 1 to No. 8 using optimization calculations, the color gamut areas may be limited within the color gamut of the most preferable color expressed by Judd's Flattery Index.

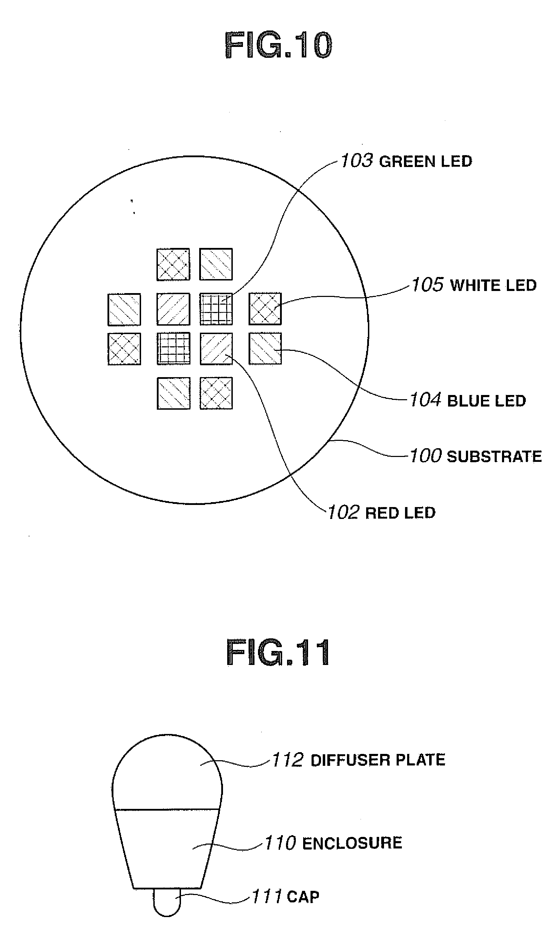

Figs. 10 and 11 are related to a third embodiment of the present invention, where Fig. 10 is a block diagram showing a schematic configuration of a light source device and Fig. 11 is an explanatory diagram showing external appearance of a lighting apparatus incorporating the light source device shown in Fig. 10.

A substrate 100 shown in Fig. 10 is placed in an enclosure 110 shown in Fig. 11. A plurality of red LEDs, green LEDs, blue LEDs, and white LEDs are disposed on the substrate 100. A lighting control device (not shown) used to turn on the LEDs is disposed in the enclosure 110. The LEDs and the lighting control device are supplied with electric power through a cap 111. A diffuser plate 112 is attached to the enclosure 110 and emergent light from the LEDs in the enclosure 110 is designed to be discharged via the diffuser plate 112.

In the light source device according to the present embodiment, a plurality of white LEDs 105 configured to emit a first white light as well as a plurality of red LEDs 102, green LEDs 103, and blue LEDs 104 are disposed on the substrate 100. Different types of hatching in Fig. 10 indicate different types of LED. As indicated by the hatching in Fig. 10, the red LEDs 102 are arranged point-symmetrically with respect to a center of the substrate 100, and so are the green LEDs 103. Around the red LEDs 102 and the green LEDs 103, the blue LEDs 104 are arranged point-symmetrically with respect to the center of the substrate 100, and so are the white LEDs 105.

That is, according to the present embodiment, the LEDs which give off light of the same color are arranged at point symmetrical locations with respect to the center of the substrate 100 while the LEDs which give off lights of colors complementary to each other are placed at adjacent locations. This makes it easy for the LEDs located adjacent to each other to produce white light and makes it possible to mix lights with fewer irregularities.

Again, by controlling the full widths at half maximum, the peak wavelengths, and the light mixing ratios of the red LEDs 102, the green LEDs 103, the blue LEDs 104, and the white LEDs 105 as shown in Tables 2 to 5 (presented above) or Fig. 9, the present embodiment provides a lighting apparatus which has a desired correlated color temperature and deviation as well as the targeted efficiency, the average color rendering index Ra, and the color gamut area ratio Ga.

By arranging the LEDs in this way, the present embodiment can reduce color irregularities on an irradiated surface. Also, by setting spacing between the LEDs to 1 mm or below, the present embodiment can reduce irregularities produced by shadows cast on the irradiated surface to a negligible level of a few millimeters or below.

In this way, the present embodiment can provide a lighting apparatus such as a downlight luminaire in which color irregularities on an irradiated surface and color irregularities produced by shadows have been relieved.

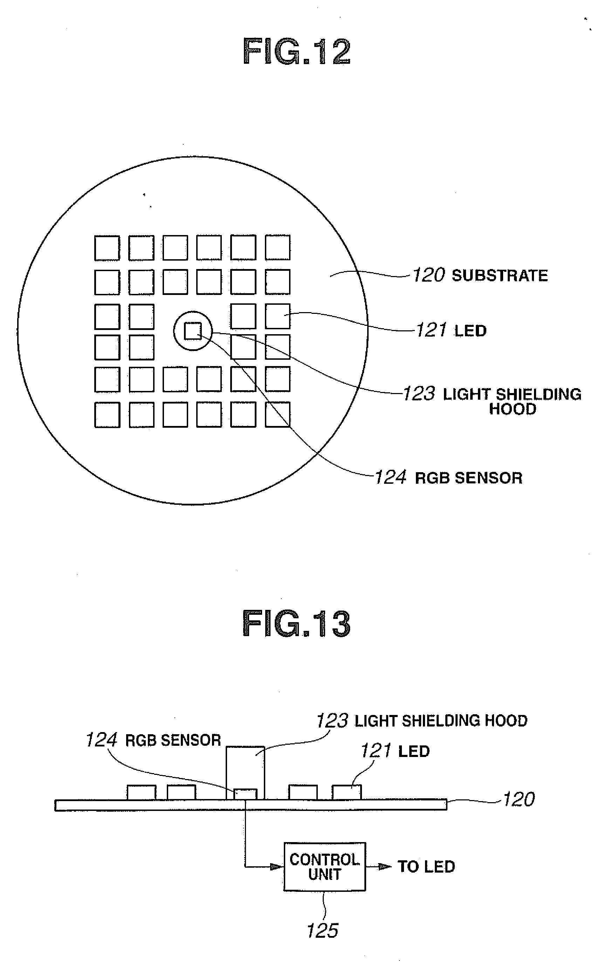

Figs. 12 and 13 are related to a fourth embodiment of the present invention and are explanatory diagrams showing a schematic configuration of a lighting apparatus, where Fig. 12 shows a planar shape of a light source device while Fig. 13 shows a sectional shape of the light source device and part of a lighting control device. Incidentally, external appearance of the lighting apparatus incorporating the light source device according to the present embodiment is the same as in Fig. 11, and thus diagrammatic illustration thereof is omitted.

As described above, by controlling the light mixing ratio among LEDs of different colors, it is possible to construct a lighting apparatus having a desired correlated color temperature and a desired color gamut area ratio Ga. However, luminous flux reduction due to heat and aged deterioration of chip material vary from LED to LED, so illumination based on light mixing could undergo changes in colors of light with the passage of time.

Thus, the present embodiment controls the LEDs by detecting a state of mixing of the lights from the LEDs and thereby prevents changes in the colors of light.

A substrate 120 shown in Fig. 12 is placed in the enclosure 110 (see Fig. 11). As shown in Figs. 12 and 13, the light source device includes a plurality of LEDs 121 placed on the substrate 120. The LEDs 121 include red LEDs, green LEDs, blue LEDs, and white LEDs.

In the example of Fig. 12, the LEDs 121 are arranged in a matrix on the substrate 120 excluding an approximately central part of the substrate 120. An RGB sensor 124 is disposed in a central part of the substrate 120. The RGB sensor 124 is surrounded by a light shielding hood 123 erected up to a level higher than emergent surfaces of the LEDs 121. Emergent light from the LEDs 121 are designed to be discharged via the diffuser plate 112 shown in Fig. 11.

Also, the emergent light from the LEDs 121 are designed to enter the RGB sensor 124 by being reflected by the diffuser plate 112. If the RGB sensor 124 detects direct light from the LEDs 121, detection results produced by the RGB sensor 124 are affected greatly by the colors of light from the LEDs 121 located around the RGB sensor 124. Thus, according to the present embodiment, the light shielding hood 123 is erected up to a level higher than the emergent surfaces of the LEDs 121 to block the direct light from the LEDs 121 from entering the RGB sensor 124.

That is, the direct light from the LEDs 121 is blocked by the light shielding hood 123 from entering the RGB sensor 124 and only light reflected from the diffuser plate 112 enters the RGB sensor 124. The light reflected from the diffuser plate 112 is a mixture of lights from the LEDs 121. The RGB sensor 124 detects a red light component, a blue light component, and a green light component in the mixture of emergent lights from the LEDs 121 and outputs detection results to a control unit 125 in the lighting control device.

Based on the detected color light components in the mixed light, the control unit 125 controls the full width at half maximum, the peak wavelength, and the light mixing ratio of each LED so that the light mixing ratios of the red LEDs, the green LEDs, the blue LEDs, and the white LEDs will match, for example, the set values shown in Tables 2 to 5 (presented above) or Fig. 9.

A relationship between current passed through the LEDs 121 and luminous fluxes from the LEDs 121 varies with characteristics of the LED chip. Therefore, the control unit 125 holds a table and a relational expression for each type of LED in advance concerning the relationship between the current and the luminous flux and performs control so as to obtain predetermined light mixing ratios using the tables and relational expressions.

This configuration makes it possible to always drive the LEDs 121 at constant light mixing ratios at all times regardless of individual differences in characteristics and aging among the LEDs. This makes it possible to stably provide a lighting apparatus which has a desired correlated color temperature and deviation as well as a targeted efficiency, the average color rendering index Ra, and the color gamut area ratio Ga.

In this way, the present embodiment can prevent changes in the colors of light by setting constant light mixing ratios regardless of the characteristics, aging, and the like of the individual LEDs.

Incidentally, although a white LED made up of a blue LED and yellow phosphor is used in the embodiments described above, a yellow LED which gives off yellow light may be adopted instead of the white LED.

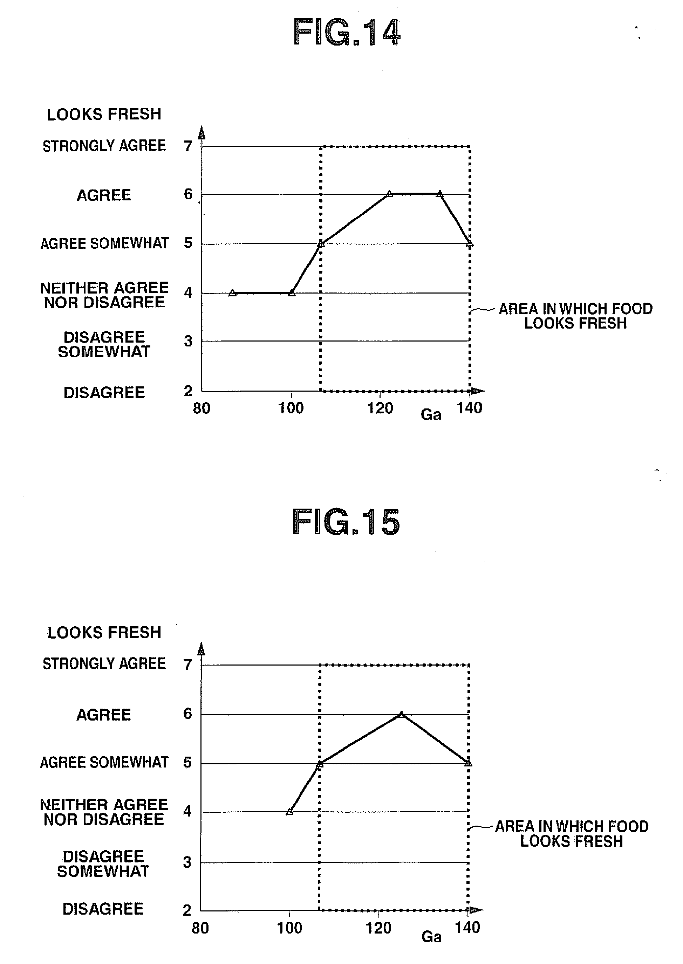

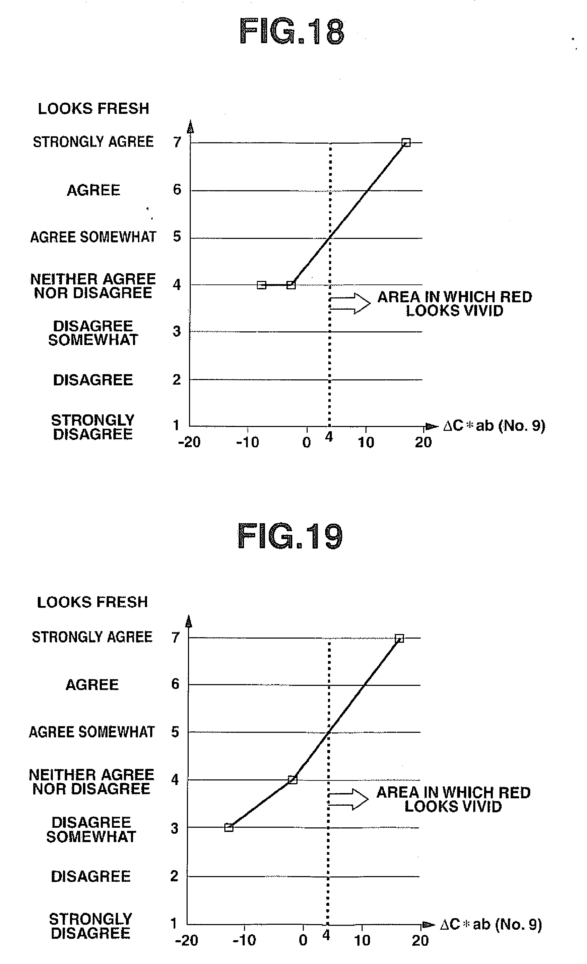

Figs. 14 to 19 are graphs for illustrating a fifth embodiment of the present invention.

The present embodiment is related to designing not only the color gamut area ratio, but also chroma differences on an a*b* chromaticity coordinate diagram based on JIS color rendering test colors to desired values for a lighting apparatus configured as shown in Fig. 1.

In the embodiments described above, the color gamut area ratio Ga has been used in the color rendering evaluation method for making colors look vivid. However, in shop lighting and the like, there is demand to make objects look particularly vivid. In Patent Document 2 (Japanese Patent Application Laid-Open Publication No. 2003-045206) and Patent Document 3 (Japanese Patent Application Laid-Open Publication No. 2006-261702) of related art, color gamut area ratios Ga and Ga4 are used as indices to prevent reductions in vividness, where Ga denotes a ratio between a color gamut area formed by connecting eight points in chromaticity coordinates when JIS color rendering test colors No. 1 to No. 8 are lighted by a test light and a color gamut area formed by connecting eight points in the chromaticity coordinates when the JIS color rendering test colors No. 1 to No. 8 are lighted by a reference light while Ga4 denotes a ratio between a color gamut area formed by connecting four points in chromaticity coordinates when JIS color rendering test colors No. 9 to No. 12 are lighted by the test light and a color gamut area formed by connecting four points in the chromaticity coordinates when the JIS color rendering test colors No. 9 to No. 12 are lighted by the reference light. Patent Documents 2 and 3 propose Ga < Ga4 as a condition for preventing reductions in vividness.

However, even if Ga < Ga4 is satisfied, there can be cases in which the color gamut spreads in a direction of green in chromaticity coordinates and contracts in a direction of red, preventing red from looking vivid or cases in which the color gamut spreads in a direction of red in chromaticity coordinates and contracts in a direction of green, preventing green from looking vivid. Consequently, the techniques described in Patent Documents 2 and 3 cannot illuminate objects in such a way as to make the objects look sufficiently vivid. Besides, a sufficient value of the average color rendering index Ra is not available.

Thus, while improving vividness in general, the present embodiment is designed to improve vividness of red obj ects by setting a chroma difference of especially a red test color, which serves as an index of vividness of red, from the reference light to a stipulated value in addition to manipulating the color gamut area ratio Ga.

As the chroma difference of the red test color from the reference light, the present embodiment uses a value (hereinafter referred to as ΔC*ab (No. 9)) obtained by subtracting a distance between a point and the origin on an a*b* chromaticity coordinate diagram when JIS color rendering test color No. 9 is lighted by the reference light from a distance between the point and the origin on the a*b* chromaticity coordinate diagram when JIS color rendering test color No. 9 is lighted by a test light.

That is, the present embodiment is designed to construct a light source device from four LEDs in total, including a white LED made up of a blue LED which glows in a blue color and a yellow phosphor which glows in a yellow color, and three LEDs---a red LED, a green LED, and a blue LED---used to produce white light, improve the color gamut area ratio Ga to 105% or above or to 110% or above by varying a power ratio among the four LEDs, and thereby set the index ΔC*ab (No. 9) to 4 or above.

Figs. 14 to 16 are graphs showing relationships between the color gamut area ratio Ga and freshness evaluation of food when the food is illuminated by a light source device made up of red, green, blue, and white LEDs, where the abscissa represents the color gamut area ratio Ga and the ordinate represents an evaluation value of freshness. Incidentally, Figs. 14 to 16 show examples of a light source device configured to provide illumination with a correlated color temperature of 2800 K and a deviation of 0.02 or below in absolute value, a light source device configured to provide illumination with a correlated color temperature of 3500 K and a deviation of 0.02 or below in absolute value, and a light source device configured to provide illumination with a correlated color temperature of 5000 K and a deviation of 0.02 or below in absolute value, respectively.

As can be seen from Fig. 14, the light source device with a correlated color temperature of 2800 K requires a color gamut area ratio Ga of approximately 110% to 140% (both inclusive) in order to get an evaluation value equal to or higher than 5 at which the object is judged to look relatively fresh.

Also, as can be seen from Fig. 15, the light source device with a correlated color temperature of 3500 K requires a color gamut area ratio Ga of approximately 105% to 140% (both inclusive) in order to get an evaluation value equal to or higher than 5 at which the object is judged to look relatively fresh.

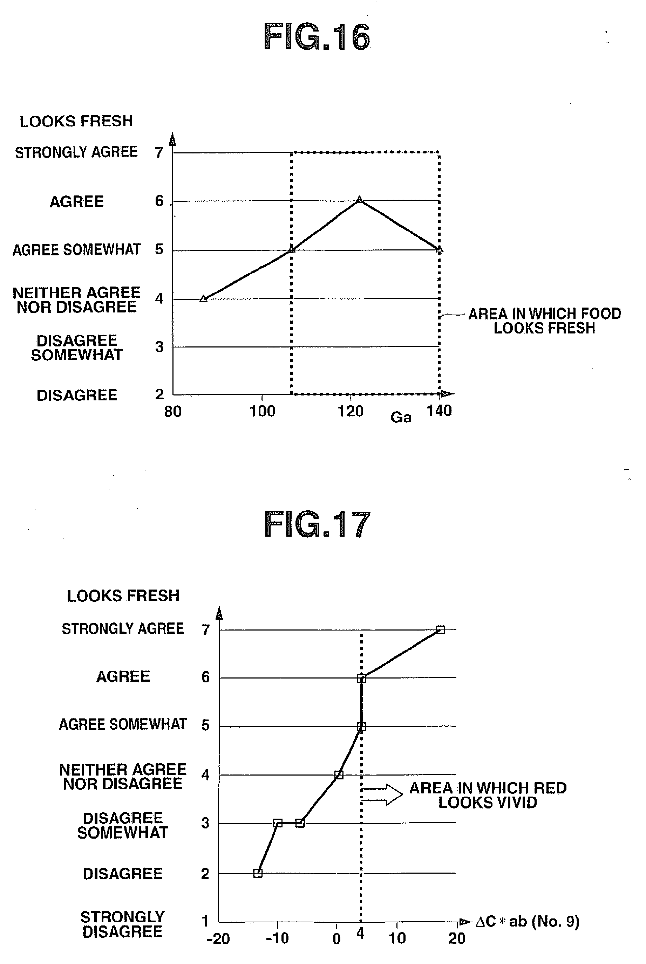

Also, as can be seen from Fig. 16, the light source device with a correlated color temperature of 5000 K requires a color gamut area ratio Ga of approximately 105% to 140% (both inclusive) in order to get an evaluation value equal to or higher than 5 at which the object is judged to look relatively fresh.

Figs. 17 to 19 are graphs showing relationships between ΔC*ab (No. 9) and freshness evaluation of red when food is illuminated by a light source device made up of red, green, blue, and white LEDs, where the abscissa represents ΔC*ab (No. 9) and the ordinate represents an evaluation value of vividness of red. Incidentally, Figs. 17 to 19 show examples of a light source device configured to provide illumination with a correlated color temperature of 2800 K and a deviation of 0.02 or below in absolute value, a light source device configured to provide illumination with a correlated color temperature of 3500 K and a deviation of 0.02 or below in absolute value, and a light source device configured to provide illumination with a correlated color temperature of 5000 K and a deviation of 0.02 or below in absolute value, respectively.

As can be seen from Figs. 17 to 19, the light source devices with a correlated color temperature of 2800 K, 3500 K, or 5000 K require ΔC*ab (No. 9) of approximately 4 or above in order to get an evaluation value equal to or higher than 5 at which red is judged to look relatively vivid.

In this way, according to the present embodiment, in a light source device made up of red, green, blue, and white LEDs, the color gamut area ratio Ga is set between 105% (or 110%) and 140% (both inclusive) and the index ΔC*ab (No. 9) is set to 4 or above, where the index ΔC*ab (No. 9) is based on a chroma difference of a red test color. Consequently, the lighting apparatus according to the present embodiment can make an illuminated object look particularly vivid. In particular, the light source device according to the present embodiment has the advantage of being capable of making food on display in a store look fresh when the food is illuminated by the light source device.

By applying the second to fourth embodiments described above to the present embodiment, it is possible to make an illuminated object look particularly vivid while designing to achieve desired values of the color gamut area ratio, the average color rendering index (Ra), and efficiency.

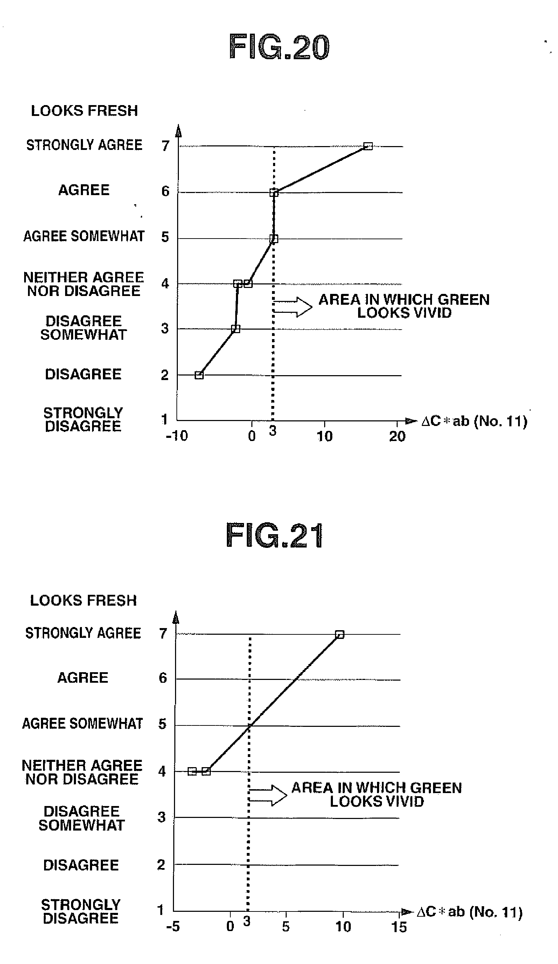

Figs. 20 to 22 are graphs for illustrating a sixth embodiment of the present invention.

The present embodiment differs from the fifth embodiment in that a light source device is designed using a chroma difference of a green test color instead of a chroma difference of a red test color. The rest of configuration is the same as that of the fifth embodiment. Thus, the present embodiment is designed to improve vividness of green objects in particular, while improving vividness in general.

As the chroma difference of the green test color from the reference light, the present embodiment uses a value (hereinafter referred to as ΔC*ab (No. 11)) obtained by subtracting a distance between a point and the origin on an a*b* chromaticity coordinate diagram when JIS color rendering test color No. 11 is lighted by the reference light from a distance between the point and the origin on the a*b* chromaticity coordinate diagram when JIS color rendering test color No. 11 is lighted by a test light.

That is, the present embodiment is designed to construct a light source device from four LEDs in total, including a white LED made up of a blue LED which glows blue and a yellow phosphor which glows yellow, and three LEDs---a red LED, a green LED, and a blue LED---used to produce white light, improve the color gamut area ratio Ga to 105% or above or to 110% or above by varying a power ratio among the four LEDs, and thereby set the index ΔC*ab (No. 11) to 3 or above or to 2 or above.

Figs. 20 to 22 are graphs showing relationships between ΔC*ab (No. 11) and freshness evaluation of green when food is illuminated by a light source device made up of red, green, blue, and white LEDs, where the abscissa represents ΔC*ab (No. 11) and the ordinate represents an evaluation value of freshness of green. Incidentally, Figs. 20 to 22 show examples of a light source device configured to provide illumination with a correlated color temperature of 2800 K and a deviation of 0.02 or below in absolute value, a light source device configured to provide illumination with a correlated color temperature of 3500 K and a deviation of 0.02 or below in absolute value, and a light source device configured to provide illumination with a correlated color temperature of 5000 K and a deviation of 0.02 or below in absolute value, respectively.

As can be seen from Figs. 20 and 21, the light source devices with a correlated color temperature of 2800 K or 3500 K require ΔC*ab (No. 11) of approximately 3 or above in order to get an evaluation value equal to or higher than 5 at which green is judged to look relatively vivid.

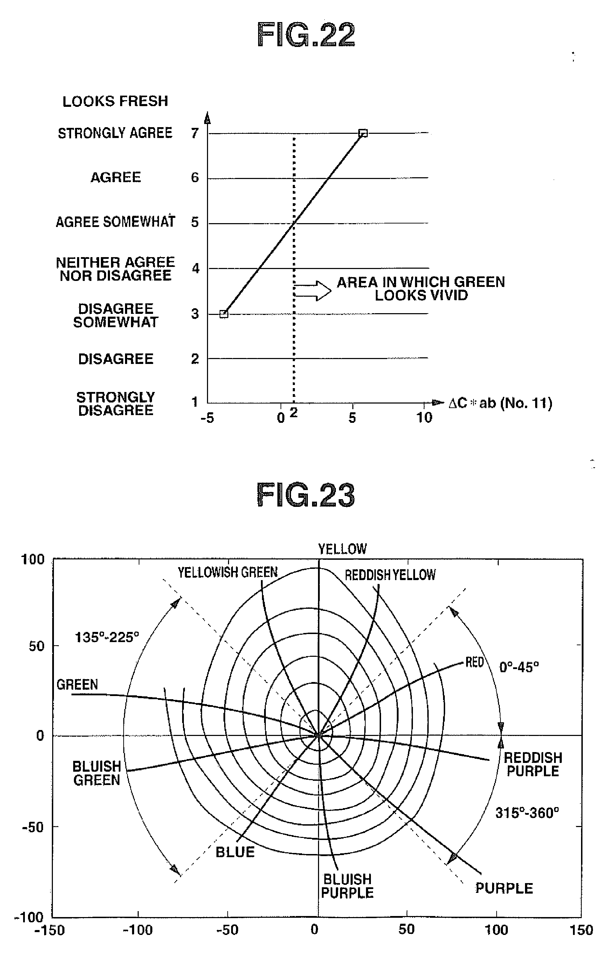

Also, as can be seen from Fig. 22, the light source device with a correlated color temperature of 5000 K requires ΔC*ab (No. 11) of approximately 2 or above in order to get an evaluation value equal to or higher than 5 at which green is judged to look relatively vivid.

The relationships between the color gamut area ratio Ga and freshness evaluation of food are as shown in Figs. 14 to 16, and the color gamut area ratio Ga is set between 105% and 140% (both inclusive) again in the present embodiment.

In this way, according to the present embodiment, in a light source device made up of red, green, blue, and white LEDs, the color gamut area ratio Ga is set between 105% and 140% (both inclusive) and the index ΔC*ab (No. 11) is set to 2 or above or to 3 or above, where the index ΔC*ab (No. 11) is based on a chroma difference of a green test color. Consequently, the lighting apparatus according to the present embodiment can make an illuminated object look particularly vivid. In particular, the light source device according to the present embodiment has the advantage of being capable of making food on display in a store look fresh when the food is illuminated by the light source device.

Again, by applying the second to fourth embodiments described above to the present embodiment, it is possible to make an illuminated object look particularly vivid while designing to achieve desired values of the color gamut area ratio, the average color rendering index (Ra), and the efficiency.

Fig. 23 is an explanatory diagram for illustrating a seventh embodiment of the present invention.

In the fifth and sixth embodiments, a value of chroma difference of red or green on the a*b* chromaticity coordinate diagram have been stipulated. The chroma difference is the difference between the distance from the origin to a point lighted by a reference light on the a*b* chromaticity coordinate diagram and the distance from the origin to the point lighted by a test light on the a*b* chromaticity coordinate diagram. Cases in which the hue of the point lighted by the test light differs markedly from red or green are not taken into consideration.

The present embodiment is related to designing not only the color gamut area ratio, but also the hue on the a*b* chromaticity coordinate diagram to a desired value for a lighting apparatus configured as shown in Fig. 1.

Fig. 23 shows a relationship between an a*b* chromaticity diagram and hues in the Munsell hue circle (A. R. Robertson, Color Research and Application, Vol. 2, No. 1, p.7-11, 1977). It can be seen that a range of red is an area with an ab hue angle (hab) of approximately 0° to 45° or 315° to 360° and that a range of green is an area with an ab hue angle (hab) of approximately 135° to 225°.

Thus, according to the present embodiment, the ab hue angle (hab) (No. 9) on the a*b* chromaticity coordinate diagram is designed to fall within an area of 0° to 45° or 315° to 360° when JIS color rendering test color No. 9 is lighted by the test light. If the hue angle falls outside the area, red will shift in hue and look yellow, blue, or green.

Also, the ab hue angle (hab) (No. 11) on the a*b* chromaticity coordinate diagram is designed to fall within an area of 135° to 225° when JIS color rendering test color No. 11 is lighted by the test light. If the hue angle falls outside the area, green will shift in hue and look yellow, blue, or red.

The color gamut area ratio Ga may have the same setting as in the fifth or sixth embodiment described above.

Also, although an example of stipulating the color gamut area ratio and the hue on the a*b* chromaticity coordinate diagram has been described in the present embodiment, it is obvious that the color gamut area ratio, the value of chroma difference on the a*b* chromaticity coordinate diagram, and the hue on the a*b* chromaticity coordinate diagram may be stipulated as with the fourth and fifth embodiments.

In this way, according to the present embodiment, in a light source device made up of red, green, blue, and white LEDs, the color gamut area ratio Ga is set between 105% and 140% (both inclusive), the hue on the a*b* chromaticity coordinate diagram is set in an area with an ab hue angle (hab) of approximately 0° to 45° or 315° to 360° as a range of red, and in an area with an ab hue angle (hab) of approximately 135° to 225° as a range of green.

Consequently, the lighting apparatus according to the present embodiment can make an illuminated object look particularly vivid. In particular, the light source device according to the present embodiment has the advantage of being capable of making food on display in a store look fresh when the food is illuminated by the light source device.

Again, by applying the second to fourth embodiments described above to the present embodiment, it is possible to make an illuminated object look particularly vivid while designing to achieve desired values of the color gamut area ratio, the average color rendering index (Ra), and the efficiency.

It should be noted that the invention described in the above embodiments is not limited to the embodiments and may be modified in various forms in the implementation stage without departing from the spirit or scope of the invention. Furthermore, the embodiments described above include inventions at various stages, and various inventions can be extracted through appropriate combinations of the disclosed components.

For example, even if some of the components are removed from any of the embodiments, the resulting configuration can be extracted as an invention as long as the configuration can solve the problems described in the Disclosure of Invention and provide the advantages described above.

The present application is based upon and claims the benefit of priority from Japanese Patent Application Laid-Open Publication No. 2009-108078, filed on April 27, 2009, and Japanese Patent Application Laid-Open Publication No.2010-044704, filed on March 1, 2010, the entire contents of which are incorporated in the specification, claims, and drawings herein by reference.

## Claims

1. A lighting apparatus comprising:
a red LED which has a peak wavelength of emission spectrum in a range of 610 to 630 nm and a full width at half maximum in a range of 10 to 20 nm;
a green LED which has a peak wavelength of emission spectrum in a range of 500 to 520 nm and a full width at half maximum in a range of 20 to 30 nm;
a blue LED which has a peak wavelength of emission spectrum in a range of 450 to 470 nm and a full width at half maximum in a range of 10 to 20 nm; and
a white LED made up of a blue light-emitting element and a yellow phosphor,
wherein the red LED generates light at a flux ratio of between 26 and 38%;
the green LED generates light at a flux ratio of between 35 and 50%;
the blue LED generates light at a flux ratio of between 0 and 2%;
the white LED generates light at a flux ratio of between 12 and 33%;
white light is obtained by additive color mixing of light from the red, green, blue, and white LEDs; and
the white light has a correlated color temperature of 2800 K or more to less than 3500 K, a deviation of 0.02 or below in absolute value, and a color gamut area ratio of 120% or more to 140% or less when the white light is used as a test light, where the color gamut area ratio is a ratio between a color gamut area formed by connecting eight points in chromaticity coordinates when JIS color rendering test colors No. 1 to No. 8 are lighted by the test light and a color gamut area formed by connecting eight points in the chromaticity coordinates when the JIS color rendering test colors No. 1 to No. 8 are lighted by a reference light.

2. The lighting apparatus according to claim 1, wherein:
the red LED generates light at a flux ratio of between 18 and 31%;
the green LED generates light at a flux ratio of between 28 and 46%;
the blue LED generates light at a flux ratio of between 0 and 2%;
the white LED generates light at a flux ratio of between 23 and 52%;
white light is obtained by additive color mixing of light from the red, green, blue, and white LEDs; and
the white light has a correlated color temperature of 3500 K or more to less than 5000 K, a deviation of 0.02 or below in absolute value, and a color gamut area ratio of 120% or more to 140% or less when the white light is used as the test light.

3. The lighting apparatus according to claim 1, wherein:
the red LED generates light at a flux ratio of between 18 and 30%;
the green LED generates light at a flux ratio of between 28 and 57%;
the blue LED generates light at a flux ratio of between 0 and 3%;
the white LED generates light at a flux ratio of between 15 and 52%;
white light is obtained by additive color mixing of light from the red, green, blue, and white LEDs; and
the white light has a correlated color temperature of 5000 K or more to 10000 K or less, a deviation of 0.02 or below in absolute value, and a color gamut area ratio of 110% or more to 140% or less when the white light is used as the test light.

4. The lighting apparatus according to claim 1, wherein:
a plurality of the red, green, blue, and white LEDs are provided; and
out of the red, green, blue, and white LEDs, LEDs complementary to each other are placed adjacent to each other and LEDs of a same type are arranged point-symmetrically.

5. The lighting apparatus according to claim 1, further comprising:
an RGB sensor configured to detect a red component, a green component, and a blue component of incident light;
a diffuser plate configured to transmit and reflect light from the red, green, blue, and white LEDs;
a light shielding member configured to block direct light from the red, green, blue, and white LEDs and give mixed light from the diffuser plate to the RGB sensor; and
a control unit configured to keep flux ratios of the light from the red, green, blue, and white LEDs constant based on detection results produced by the RGB sensor.

6. A lighting apparatus, comprising:
a light source configured to radiate an illuminating light by additively mixing color lights from a red LED, a green LED, a blue LED, and a white LED, wherein
the light source has a color gamut area ratio of 105% or more to 140% or less when the illuminating light radiated from the light source is used as a test light, has a chroma difference of 4 or above between the illuminating light and a reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light, has a correlated color temperature of 2800 K or more to less than 5000 K, and has a deviation duv of 0.02 or below in absolute value, where the color gamut area ratio is a ratio between a color gamut area formed by connecting four points in chromaticity coordinates when JIS color rendering test colors No. 9 to No. 12 are lighted by the test light and a color gamut area formed by connecting four points in the chromaticity coordinates when the JIS color rendering test colors No. 9 to No. 12 are lighted by the reference light.

7. The lighting apparatus according to claim 6, wherein the light source has a color gamut area ratio of 105% or more to 140% or less when the illuminating light radiated from the light source is used as the test light, has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 2800 K or more to less than 3500 K, and has a deviation duv of 0.02 or below in absolute value.

8. The lighting apparatus according to claim 6, wherein the light source has a color gamut area ratio of 105% or more to 140% or less when the illuminating light radiated from the light source is used as the test light, has a chroma difference of 2 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 5000 K or above, and has a deviation duv of 0.02 or below in absolute value.

9. The lighting apparatus according to claim 6, wherein the light source has a color gamut area ratio of 105% or more to 140% or less when the illuminating light radiated from the light source is used as the test light, has an area of 0° to 45° or an area of 315° to 360° in terms of an ab hue angle (hab) (No. 9) of first chromaticity on an a*b* chromaticity coordinate diagram when the first chromaticity is plotted on the a*b* chromaticity coordinate diagram with a color chip of JIS color rendering test color No.9 lighted by the illuminating light radiated from the light source, has an area of 135° to 225° in terms of an ab hue angle (hab) (No. 11) of second chromaticity on the a*b* chromaticity coordinate diagram when the second chromaticity is plotted on the a*b* chromaticity coordinate diagram with a color chip of JIS color rendering test color No. 11 lighted by the illuminating light, has a correlated color temperature of 2800 K or more to less than 5000 K, and has a deviation duv of 0.02 or below in absolute value.

10. The lighting apparatus according to claim 6, wherein the light source has a color gamut area ratio of 105% or more to 140% or less when the illuminating light radiated from the light source is used as the test light, has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light, has a correlated color temperature of 2800 K or more to less than 5000 K, has a deviation duv of 0.02 or below in absolute value, and has an area of 0° to 45° or an area of 315° to 360° in terms of an ab hue angle (hab) (No. 9) of first chromaticity on the a*b* chromaticity coordinate diagram when the first chromaticity is plotted on the a*b* chromaticity coordinate diagram with a color chip of JIS color rendering test color No. 9 lighted by the illuminating light.

11. The lighting apparatus according to claim 6, wherein the light source has a color gamut area ratio of 105% or more to 140% or less when the illuminating light radiated from the light source is used as the test light, has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 2800 K or more to less than 3500 K, has a deviation duv of 0.02 or below in absolute value, and has an area of 135° to 225° in terms of an ab hue angle (hab) (No. 11) of second chromaticity on the a*b* chromaticity coordinate diagram when the second chromaticity is plotted on the a*b* chromaticity coordinate diagram with a color chip of JIS color rendering test color No. 11 lighted by the illuminating light.

12. The lighting apparatus according to claim 6, wherein the light source has a color gamut area ratio of 105% or more to 140% or less when the illuminating light radiated from the light source is used as the test light, has a chroma difference of 2 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light, has a correlated color temperature of 5000 K, has a deviation duv of 0.02 or below in absolute value, and has an area of 135° to 225° in terms of an ab hue angle (hab) (No. 11) of second chromaticity on the a*b* chromaticity coordinate diagram when the second chromaticity is plotted on the a*b* chromaticity coordinate diagram with a color chip of JIS color rendering test color No. 11 lighted by the illuminating light.

13. The lighting apparatus according to claim 1, wherein:
white light is obtained by additive color mixing of light from the red, green, blue, and white LEDs; and
the white light has a color gamut area ratio of 105% or more to 140% or less when the white light is used as the test light and has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light.

14. The lighting apparatus according to claim 2, wherein:
white light is obtained by additive color mixing of light from the red, green, blue, and white LEDs; and
the white light has a color gamut area ratio of 105% or more to 140% or less when the white light is used as the test light and has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light.

15. The lighting apparatus according to claim 3, wherein:
white light is obtained by additive color mixing of light from the red, green, blue, and white LEDs; and
the white light has a color gamut area ratio of 105% or more to 140% or less when the white light is used as the test light and has a chroma difference of 4 or above between the illuminating light and the reference light on an a*b* chromaticity coordinate diagram when chromaticity is plotted on the a*b* chromaticity coordinate diagram with a color chip of JIS color rendering test color No. 9 lighted by the illuminating light radiated from the light source or by the reference light.

16. The lighting apparatus according to claim 1, wherein:
white light is obtained by additive color mixing of light from the red, green, blue, and white LEDs; and
the white light has a color gamut area ratio of 105% or more to 140% or less when the white light is used as the test light and has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light.

17. The lighting apparatus according to claim 2, wherein:
white light is obtained by additive color mixing of light from the red, green, blue, and white LEDs; and
the white light has a color gamut area ratio of 105% or more to 140% or less when the white light is used as the test light and has a chroma difference of 3 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light.

18. The lighting apparatus according to claim 3, wherein:
white light is obtained by additive color mixing of light from the red, green, blue, and white LEDs;
the white light has a color gamut area ratio of 105% or more to 140% or less when the white light is used as the test light and has a chroma difference of 2 or above between the illuminating light and the reference light on an a*b* chromaticity coordinate diagram when chromaticity is plotted on the a*b* chromaticity coordinate diagram with a color chip of JIS color rendering test color No. 11 lighted by the illuminating light radiated from the light source or by the reference light.

19. The lighting apparatus according to claim 1, further comprising:
an apparatus body in which the red LED, the green LED, the blue LED, and the white LED are disposed; and
a lighting control device configured to control an ON state or an OFF state of the red LED, the green LED, the blue LED, and the white LED.
